# EUROPÄISCHE PATENTSCHRIFT

(11) **EP 1 573 346 B1**
(45) Veröffentlichungstag und Bekanntmachung des Hinweises auf die Patenterteilung: **01.08.2007**
(21) Anmeldenummer: 03813139.7
(22) Anmeldetag: 17.12.2003
(51) Int. Cl.: G01R 31/36

(54) **VERFAHREN UND SCHALTUNGSANORDNUNG ZUR VERMESSUNG VON ELEKTROCHEMISCHEN ZELLEN IN EINER SERIENVERSCHALTUNG**
METHOD AND CIRCUIT ARRANGEMENT FOR THE MEASUREMENT OF ELECTROCHEMICAL CELLS IN A SERIAL CIRCUIT
PROCEDE ET MONTAGE POUR EFFECTUER DES MESURES SUR DES PILES ELECTROCHIMIQUES DANS UN MONTAGE SERIE

(30) Priorität: 17.12.2002 DE 10260894
(43) Veröffentlichungstag der Anmeldung: 14.09.2005
(73) Patentinhaber: Fraunhofer-Gesellschaft zur Förderung der angewandten Forschung e.V., 80686 München (DE)
(72) Erfinder: HAKENJOS, Alexander, 79295 Sulzburg (DE)
(74) Vertreter: Pfenning, Meinig & Partner GbR
(86) Internationale Anmeldenummer: PCT/EP2003/014431
(87) Internationale Veröffentlichungsnummer: WO 2004/055535

(56) Entgegenhaltungen:
- US-A- 5 557 189
- US-A1- 2003 088 376

## Beschreibung

Die Erfindung betrifft ein Verfahren und eine Schaltungsanordnung zur Vermessung von elektrochemischen Zellen wie z.B. Brennstoffzellen in einer Serienverschaltung nach dem Oberbegriff des Anspruchs 1 bzw. 8.

Um durch Addition der Ausgangsspannungen einzelner elektrochemischer Zellen größere Gesamtspannungen zu erzielen, werden mehrere Zellen in Serie verschaltet. Dabei werden die Zellen häufig räumlich dicht gepackt, um den Platzbedarf so gering wie möglich zu halten. Zur Optimierung derartiger Serienverschaltungen muss das Verhalten einzelner Zellen unter Bedingungen der Serienverschaltung bekannt sein. Veränderungen der Zelleigenschaften unter den Bedingungen der Serienverschaltung gegenüber den Eigenschaften einer einzelnen, räumlich isolierten Zelle, beispielsweise durch thermische Einflüsse der benachbarten Zellen, machen entsprechende Messungen unter Beibehaltung der Serienverschaltung erforderlich.

Bekannt ist ein Verfahren zur Messung der ohmschen Verluste einzelner Zellen in einer Serienverschaltung mittels einer Stromunterbrechungsmethode und eine entsprechende Schaltungsanordnung, die von Tuomas Mennola et al. in Journal of Power Sources 4931, Jg. 2002, S. 1 - 12 beschrieben werden. Bei der dort beschriebenen und angewandten Anordnung werden die einzelnen Zellspannungen durch Abnahme der Spannungen an den kathoden- und anodenseitigen Stromableitern der einzelnen Zellen der belasteten Serienverschaltung gemessen. Durch gleichzeitige Messung des die Serienverschaltung durchfließenden Stroms kann so der Zusammenhang zwischen diesem Strom und den einzelnen Zellspannungen ermittelt werden.

Von besonderem Interesse ist dieser Zusammenhang für den Fall eines zeitlich veränderlichen Stromes. Bei der bekannten Schaltungsanordnung, die in der oben zitierten Veröffentlichung beschrieben wird, muss hierfür der Strom in allen Zellen der Serienverschaltung simultan in gleicher Weise verändert werden. Insbesondere muss also zur Untersuchung des Verhaltens einer einzelnen Zelle unter zeitlich veränderlichem Strom der durch die benachbarten Zellen fließende Strom in gleicher Weise wie der durch die betreffende Zelle fließende Strom zeitlich verändert werden. Ein Nachteil der bekannten Anordnung und des bekannten Verfahrens ist also die Unmöglichkeit, das Verhalten einzelner Zellen unter den Bedingungen der Serienverschaltung unter zeitlich veränderlichem Strom zu untersuchen, ohne dabei gleichzeitig die Bedingungen in den Nachbarzellen zeitlich korreliert zu ändern.

Davon abweichend sind in der Druckschrift US-A-5 557 189 Schaltungsanordnungen gezeigt, bei denen Untergruppen von Zellen einer Serienverschaltung oder auch sämtliche Einzelzellen einer Serienverschaltung mit jeweils eigenen Lasten belastet sind. Die dort beschriebenen Schaltungsanordnungen dienen zur Überwachung von Ladungszuständen der entsprechenden Einzelzellen bzw. Gruppen von Zellen bei einem Betrieb oder einem Wiederaufladevorgang der entsprechenden Serienverschaltung von Zellen. Hier geht es also nicht um eine Untersuchung der Eigenschaften einzelner Zellen oder von Gruppen von Zellen unter den Bedingungen einer Serienverschaltung, sondern um eine Feststellung aktueller Ladezustände von Zellen oder Gruppen von Zellen im Betrieb. Dementsprechend sind in den zuletzt genannten Druckschriften auch keine Mittel zur Untersuchung des Verhaltens einer einzelnen Zelle oder mehrerer Zellen unter definierten zeitlichen veränderlichen Strömen vorgesehen.

Der Erfindung liegt also die Aufgabe zugrunde, ein Verfahren und eine entsprechende Schaltungsanordnung zu finden, die es ermöglichen, in einer Serienverschaltung elektrochemischer Zellen den durch einzelne Zellen fließenden Strom bei einer Messung elektrischer Eigenschaften dieser Zellen gezielt und unabhängig von dem Strom, mit dem die anderen Zellen beaufschlagt sind, festzulegen bzw. zu verändern.

Diese Aufgabe wird erfindungsgemäß gelöst durch die kennzeichnenden Merkmale des Anspruchs 1 bzw. 6 in Verbindung mit den Merkmalen des Oberbegriffs des Anspruchs 1 bzw. 6. Vorteilhafte Ausgestaltungen der Erfindung sind in den Unteransprüchen beschrieben.

Vorteilhaft an der Verbindung von Untergruppen der Zellen mit separaten Lasten ist die Möglichkeit, den durch die entsprechenden Gruppen von Zellen fließenden Strom gezielt festzulegen oder zu verändern, ohne die gleiche Änderung des durch alle anderen Zellen fließenden Stroms und eine damit korrelierte Änderung der in den anderen Zellen herrschenden Bedingungen zu erzwingen. So werden selektive Messungen an Untergruppen von Zellen oder auch an einzelnen Zellen der Serienverschaltung bei gleichzeitiger, davon unabhängiger Festlegung der Bedingungen in den übrigen Zellen möglich.

Durch die Verbindung mindestens einer der einzelnen Zellen mit einer eigenen separaten Last wird in einer bevorzugten Ausführung der Erfindung die Untersuchung der Eigenschaften dieser Zelle insbesondere unter zeitlich veränderlichen Strömen unter den Bedingungen der Serienschaltung unter unabhängig definierten Bedingungen in den Nachbarzellen möglich. Sind alle Zellen der Serienverschaltung jeweils mit einer eigenen separaten Last verbunden, können derartige Untersuchungen für alle Einzelzellen mit ein und derselben Schaltungsanordnung durchgeführt werden.

Die durch die einzelnen Zellen bzw. Gruppen von Zellen fließenden Ströme können durch die Wahl von Lasten entsprechender elektrischer Eigenschaften wie ohmscher Widerstände, Induktivitäten oder Kapazitäten festgelegt werden. Durch Messung dieser Ströme und der zwischen den Polen der einzelnen Zellen anliegenden Spannungen, die sich durch die-von den Zellen selbst generierten Spannungen und Veränderungen derselben durch den fließenden Strom aufgrund ohmscher Widerstände, elektrochemischer Superpotentiale und dergleichen ergeben, können insbesondere Strom-Spannungscharakteristika einer einzelnen oder mehrerer Zellen ermittelt werden. Zur Messung von einzelnen Punkten der Strom-Spannungskennlinie einer Einzelzelle oder einer Gruppe von Zellen werden die entsprechenden Zellen mit einem definierten Strom beaufschlagt. Dies kann durch die Wahl definierter, einfacher ohmscher Widerstände als Lasten der Zellen oder Zellgruppen geschehen.

Die Wahl von in ihren elektrischen Eigenschaften wie Widerstand, Induktivität oder Kapazität kontrolliert zeitlich veränderlichen Lasten resultiert in einer Beaufschlagung der Zellen mit einem definierten zeitlich veränderlichen Strom. Das ermöglicht die unabhängige Untersuchung des Verhaltens einzelner Zellen oder mehrerer Zellen unter veränderlichem Strom unter definierten und davon unabhängigen Bedingungen in den anderen Zellen. Entscheidend ist, dass der Strom nicht in jeder Zelle gleich sein muss, in einigen Zellen kann er auch zeitlich konstant sein. Messanordungen zum Aufzeichnen der zeitlichen Verläufe der Zellspannungen und der durch die Zellen fließenden Ströme erlauben die für derartige Untersuchngen nötigen Auswertungen.

Impedanzmessungen an einzelnen oder Gruppen von Einzelzellen werden durch Wahl von Lasten möglich, die ihren elektrischen Eigenschaften periodisch oder mit einer Superposition von Perioden zeitlich veränderlich sind. Das resultiert in einer Beaufschlagung der entsprechenden Zellen mit einem definierten Strom, der sich aus einem beliebigen Gleichstromanteil und einem Wechselstromanteil einer bestimmten Frequenz oder einer Superposition mehrerer Frequenzen zusammensetzt. In ähnlicher Weise ist die gezielte Beaufschlagung von Einzelzellen oder von Gruppen von Einzelzellen mit einem Rauschen und damit die Untersuchung des Verhaltens der entsprechenden Zellen unter Rauschen möglich.

Zur Ermittlung der Wechselspannungsanteile bzw. Wechselstromanteile der zeitlichen Verläufe der einzelnen Zellspannungen bzw. der durch die einzelnen fließenden Ströme können mit entsprechenden Vorrichtungen Verfahren wie Lock-In-Verstärkung, Filterung, Fourieranalyse oder Laplaceanalyse angewandt werden. Die Impedanzen errechnen sich dann als Quotienten der einzelnen Wechselspannungs- und Wechselstromanteile. Derartige Verfahren zur Impedanzmessung an einzelnen Zellen oder Gruppen von Einzelzellen sind auch auf dem Stand der Technik entsprechende Schaltungsanordnungen anwendbar, wenn auch unter Inkaufnahme des oben aufgeführten Nachteils.

Bei allen beschriebenen Messungen an Einzelzellen oder Untergruppen der in Serie verschalteten Zellen mit einer erfindungsgemäßen Schaltungsanordnung können die Ströme, mit denen die übrigen Zellen beaufschlagt sind, von den Messungen unabhängig festgelegt werden.

Zwei Ausführungsbeispiele der vorliegenden Erfindung sollen anhand folgender Figuren erläutert werden. Es zeigen:
- Fig. 1: den Schaltplan einer erfindungsgemäßen Schaltungsanordnung für den Fall einer Serienverschaltung von sieben einzelnen Zellen, bei der eine der Einzelzellen mit einer eigenen Last verbunden ist,
- Fig. 2: den Schaltplan einer erfindungsgemäßen Schaltungsanordnung für die Vermessung der Einzelzellen einer Serienverschaltung von sieben Zellen, bei der alle Zellen jeweils mit einer eigenen separaten Last verbunden sind.

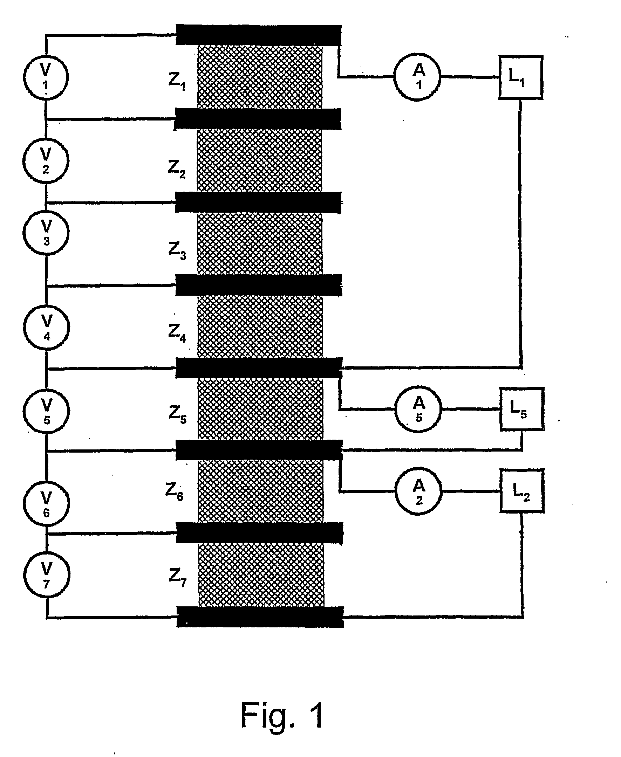

Der in Fig. 1 dargestellte Schaltplan zeigt eine Anordnung von sieben in Serie verschalteten einzelnen Brennstoffzellen Z₁ bis Z₇. Wie dargestellt räumlich dicht aufeinander gepackt bilden diese Zellen einen sogenannten Stack. Zur Spannungsmessung der zwischen den Polen der einzelnen Zellen anliegenden Spannungen ist jeweils zwischen anoden- und kathodenseitigem Stromableiter jeder Zelle ein Spannungsmessgerät Vᵢ geschaltet, das beispielsweise als Oszilloskop ausgestaltet sein kann. Für die Spannungsabnahme zwischen zwei Zellen des Stacks ist dabei jeweils die anodenseitige Stromableitung mit der kathodenseitigen Stromableitung der nächsten Zelle identisch und wird durch eine zwischen den einzelnen Zellen liegende Bipolarplatte gebildet. Erfindungsgemäß ist im dargestellten Beispiel die Einzelzelle Z₅ mit einer eigenen Last L₅ verbunden, welche nur diese Zelle Z₅ belastet. Die der Zelle Z₅ vor- und nachgeschalteten Zellen Z₁ bis Z₄ bzw. Z₆ und Z₇ sind jeweils als Gruppe mit einer Last L₁ bzw. L₂ verbunden. Die Verbindung ist dabei, wie für die Spannungsmessgeräte Vᵢ, über die als Stromableiter der Zellen dienenden Bipolarplatten bzw. Endplatten gegeben. Zur Messungen der die Zellen Zᵢ durchfließenden Ströme sind in die stromführenden Verbindungen der jeweiligen Last Zᵢ mit der Zelle bzw. den Zellen Zᵢ Strommessgeräte Aᵢ geschaltet, die wie die Spannungsmessgeräte Vᵢ zweckmäßiger Weise so ausgestaltet sind, dass sie ein Aufzeichnen der zeitlichen Verläufe der ermittelten Messwerte erlauben, zum Beispiel als Oszillographen. Die Lasten Lᵢ sind als in ihren elektrischen Eigenschaften zeitlich kontrolliert veränderbar ausgestaltet, insbesondere in ihren ohmschen Widerständen. Das ermöglicht eine gezielte Beaufschlagung der Zelle Z₅ und der ihr vor- bzw. nachgeschalteten Zellgruppe mit einem definierten, auch zeitlich veränderlichen, Strom. Mit der Schaltungsanordnung des vorliegenden Beispiels kann an der Zelle Z₅ eine Messung durchgeführt werden, ohne dass die restlichen Zellen der Serienverschaltung davon direkt durch eine zur Messung notwendige Stromhöhe oder Stromhöhenvariation in der Zelle Z₅ beeinflusst werden.

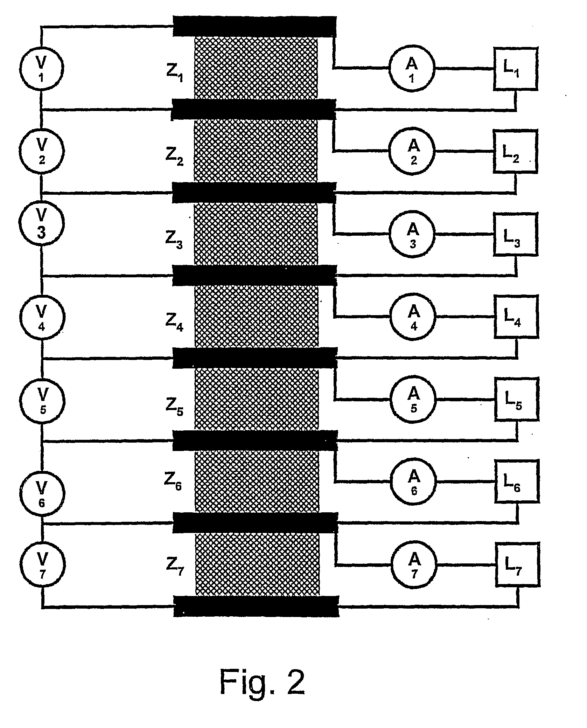

Bei der in Fig. 2 dargestellten Schaltungsanordnung für die gleiche Anordnung von serienverschalteten Zellen ist jede der Zellen Z₁ bis Z₇ über die ihre jeweils kathoden- oder anodenseitige Stromableitung bildende Bipolarplatte bzw. Endplatte mit einer eigenen separaten Last Lᵢ verbunden, welche wie im oben beschriebenen Ausführungsbeispiel zur gezielten Beaufschlagung der entsprechenden Zelle mit einem Strom kontrollierbar veränderbare elektrische Eigenschaften hat. Dementsprechend sind sieben Strommessgeräte Aᵢ in den stromführenden Verbindungen der Lasten Lᵢ mit den jeweiligen Zellen Zᵢ angeordnet. Zur Spannungsmessung der zwischen den zwei Polen jeder Zelle anliegenden Spannungen ist wie beim zuvor beschriebenen Ausführungsbeispiel jeweils ein Spannungsmessgerät Vᵢ zwischen den kathoden- und anodenseitigen Sromableiter jeder Zelle geschaltet. Die Schaltungsanordnung der Fig. 2 erlaubt es, für jede der Einzelzellen der Serienverschaltung Messungen auch unter zeitlich veränderlichen Strömen durchzuführen und dabei die durch die jeweilige Stromhöhen verursachten Bedingungen in den anderen Zellen davon unabhängig zu wählen. Auch können an verschiedenen Zellen oder Gruppen von Zellen gleichzeitig verschiedene Messungen durchgeführt werden. Es können auch nur Teile der Serienverschaltung mit Strom beaufschlagt werden.

Unabhängig von der genauen Ausgestaltung einer erfindungsgemäßen Schaltungsanordnung sind mit Blick auf möglichst umfangreiche Untersuchungsmöglichkeiten solche Ausführungen vorzuziehen, bei denen die Lasten in ihren elektrischen Eigenschaften zeitlich kontinuierlich veränderlich ausgestaltet sind, wodurch eine Beaufschlagung der entsprechenden Zellen oder Untergruppen von Zellen mit einem zeitlich kontinuierlich veränderlichen Strom ermöglicht wird. Von besonderem Interesse ist dabei eine Beaufschlagung mit einem definierten Wechselstrom oder einem Strom mit definiertem Wechselstromanteil, was mit in ihren elektrischen Eigenschaften sinusartig periodisch veränderlich ausgestaltete Lasten möglich wird.

Die elektrischen Eigenschaften können dabei in einem einfachen Fall durch einen entsprechend definierten (also gegebenenfalls zeitlich veränderlichen) ohmschen Widerstand, aber auch durch Größen wie Kapazitäten oder Induktivitäten gegeben sein. Auch muss es sich bei den Lasten nicht oder nicht nur um Verbraucher bzw. Senken handeln, vielmehr können auch Spannungsquellen (ggf. mit zeitlich veränderlichen Ausgangsspannungen) als Lasten zum Einsatz kommen. Damit ergeben sich noch weiterreichende Möglichkeiten für eine Beaufschlagung der Zellen mit Strom und dadurch für eine Wahl von Testbedingungen in den Zellen.

Die Lasten können bei besonders vorteilhaften Weiterbildungen der Erfindung als geregelte Lasten ausgeführt sein, und zwar unabhängig davon, ob Verbraucher oder als Spannungsquellen als Lasten verwendet werden. Eine entsprechende Regelung kann für einen definierten oder/und definiert zeitlich veränderlichen Strom durch die entsprechende Last und damit durch die entsprechende einzelne Zelle oder Untergruppe von Zellen sorgen. Die Regelung kann durch eine automatische Anpassung genannter elektrischer Eigenschaften der Last bei einer Änderung äußerer Bedingungen (beipielsweise einer Änderung einer Ausgangsspannung einer Zelle durch eine Temperaturänderung) erfolgen.

Schließlich ist klarzustellen, dass eine von der Erfindung vorgesehene Messung des durch die einzelnen Zellen fließenden Stroms durch eine Messung der durch die Lasten fließenden Ströme erfolgen kann. Mit den letztgenannten Ströme liegen aufgrund der Kirchhoffschen Regeln auch die Ströme durch die Zellen fest. Da Spannungsmessgeräte in der Regel ausgesprochen hochohmig ausgeführt werden, können dabei normalerweise solche Ströme vernachlässigt werden, die durch Spannungsmessgeräte fließen, von denen vorzugsweise jeweils eines mit zwei Polen jeder einzelnen Zelle verbunden ist. Aus dem Gesagten ergibt sich, dass bei einem besonders einfachen Aufbau einer erfindungsgemäßen Schaltung jeweils ein Strommessgerät in eine leitende Verbindung jeder Last mit der entsprechenden, mit dieser Last verbundenen Zelle oder Untergruppe von Zellen geschaltet werden kann. Dabei ist unter einer Belastung einer einzelnen Zelle oder einer Untergruppe von Zellen bzw. unter deren Verbindung mit einer Last bei nahe liegenden Ausführungsbeispielen eine Parallelschaltung dieser Last mit der entsprechenden Zelle oder Untergruppe von Zellen zu verstehen.

## Patentansprüche

1. Verfahren zur Vermessung von elektrischen Eigenschaften elektrochemischer Zellen in einer Serienverschaltung, bei der simultan die belasteten Zellen durchfließender Strom und zwischen den Polen einzelner Zellen der Serienverschaltung anliegende Spannungen gemessen werden,
wobei der durch die Zellen fließende Strom für mindestes zwei Untergruppen der Zellen bei gruppenweiser Belastung der Untergruppen mit separaten Lasten (Lᵢ) separat gemessen wird,
**dadurch gekennzeichnet,**
**dass** die Zellen durch in ihren elektrischen Eigenschaften periodisch, mit einer Superposition von Perioden oder rauschartig zeitlich veränderliche Lasten mit definiertem Strom beaufschlagt werden, der sich aus einem beliebigen Gleichstromanteil und einem Wechselstromanteil einer bestimmten Frequenz oder einer Superposition mehrerer Frequenzen zusammensetzt oder einen Rauschanteil hat.

2. Verfahren nach Anspruch 1, **dadurch gekennzeichnet, dass** mindestens eine der mindestens zwei Untergruppen durch eine einzige Zelle gebildet wird.

3. Verfahren nach Anspruch 1, **dadurch gekennzeichnet, dass** der durch die Zellen fließende Strom für jede Zelle bei separater Belastung jeder Zelle mit jeweils einer eigenen Last separat gemessen wird.

4. Verfahren nach einem der Ansprüche 1 bis 3, **dadurch gekennzeichnet, dass** die Zellen durch Wahl von Lasten jeweils definierter elektrischer Eigenschaften wie ohmscher Widerstände, Kapazitäten oder Induktivitäten mit jeweils definiertem Strom beaufschlagt werden.

5. Verfahren nach einem der Ansprüche 1 bis 4, **dadurch gekennzeichnet, dass** die Wechselspannungsanteile und/oder Wechselstromanteile der zeitlichen Verläufe der einzelnen Zellspannungen bzw. der durch die einzelnen Zellen fließenden Ströme durch Verfahren wie Lock-In-Verstärkung, Filterung, Fourieranalyse oder Laplaceanalyse ermittelt werden.

6. Schaltungsanordnung zur Vermessung von elektrischen Eigenschaften elektrochemischer Zellen in einer Serienverschaltung mit einer Messanordnung zur Messung von die belasteten Zellen durchfließendem Strom und von zwischen den Polen einzelner Zellen der Serienverschaltung anliegenden Spannungen, wobei die Zellen in mindestens zwei Untergruppen gruppenweise mit separaten Lasten (Lᵢ) belastet sind,
**dadurch gekennzeichnet,**
**dass** die Lasten in ihren elektrischen Eigenschaften periodisch, mit einer Superposition von Perioden oder rauschartig zeitlich veränderlich ausgestaltet sind.

7. Schaltungsanordnung nach Anspruch 6, **dadurch gekennzeichnet, dass** mindestens eine der mindestens zwei Untergruppen aus einer einzigen Zelle besteht.

8. Schaltungsanordnung nach Anspruch 6, **dadurch gekennzeichnet, dass** alle Zellen der Serienverschaltung jeweils mit einer separaten Last verbunden sind.

9. Schaltungsanordnung nach einem der Ansprüche 6 bis 8, **dadurch gekennzeichnet, dass** die Lasten definierte elektrische Eigenschaften wie ohmsche Widerstände, Kapazitäten oder Induktivitäten haben.

10. Schaltungsanordnung nach einem der Ansprüche 6 bis 9, **dadurch gekennzeichnet, dass** die Messanordnung zur Strom- und Spannungsmessung mit Vorrichtungen wie Lock-In-Verstärkern, Filtern oder Geräten zur Fourier- oder Laplaceanalyse versehen ist zur Ermittlung der Wechselspannungs- und/oder Wechselstromanteile der zeitlichen Verläufe der einzelnen Zellspannungen bzw. der durch die einzelnen Zellen fließenden Ströme.

11. Schaltungsanordnung nach einem der Ansprüche 8 bis 10, **dadurch gekennzeichnet, dass** die Lasten definierte elektrische Eigenschaften wie ohmsche Widerstände, Kapazitäten oder Induktivitäten haben.

12. Schaltungsanordnung nach Anspruch 11, **dadurch gekennzeichnet, dass** die Lasten in ihren elektrischen Eigenschaften zeitlich veränderlich ausgestaltet sind zur Beaufschlagung der Zellen mit einem jeweils definierten zeitlich veränderlichen Strom.

13. Schaltungsanordnung nach Anspruch 12, **dadurch gekennzeichnet, dass** die Lasten in ihren elektrischen Eigenschaften periodisch, mit einer Superposition von Perioden oder rauschartig zeitlich veränderlich ausgestaltet sind.

14. Schaltungsanordnung nach einem der Ansprüche 12 oder 13, **dadurch gekennzeichnet, dass** die Messanordnung zur Strom- und Spannungsmessung mit Vorrichtungen wie Lock-In-Verstärkern, Filtern oder Geräten zur Fourier- oder Laplaceanalyse versehen ist zur Ermittlung der Wechselspannungs- und/oder Wechselstromanteile der zeitlichen Verläufe der einzelnen Zellspannungen bzw. der durch die einzelnen Zellen fließenden Ströme.

## Claims

1. Method for measurement of electrical characteristics of electrochemical cells in a serial circuit, whereby power flowing through the cells under load and voltage at the poles of individual cells of the serial circuit are measured simultaneously, whereby the power flowing through the cells is measured separately for at least two sub-groups of the cells for grouped loading of the sub-cells with separate loads (L;), **characterised in that** the cells are loaded with power by means of electrically periodical loads with a super position of periods or differently timed noise loads, consisting of any random direct current component and an alternating current component of a certain frequency or a super position of several frequencies, or a noise component.

2. Method according to Claim 1, **characterised in that** at least one of the at least two sub-groups is formed by a single cell.

3. Method according to Claim 1, **characterised in that** the power flowing through the cells is measured separately for each cell under separate load for each cell for that relevant own load.

4. Method according to one of the Claims 1 to 3, **characterised in that** the cells are each supplied with defined power by selecting loads with defined electric characteristics such as ohmic resistance, capacity or inductivity.

5. Method according to one of the Claims 1 to 4, **characterised in that** the alternating voltage components and/or the alternating current components of the timed sequences of the individual cell voltages, e.g. the power flowing through the individual cells are detected by means of methods such as lock-in amplification, filtering, Fourier analysis, or Laplace analysis.

6. Circuit arrangement for the measurement of electrical characteristics of electrochemical cells in a serial circuit with a measuring arrangement for measuring the power flowing through the cells under load, and the voltages applied between the poles of individual cells of the serial circuit, whereby the cells are placed under separate loads (L;) of groups of at least two sub-groups, **characterised in that** the electrical characteristics of the loads are designed to change periodically, with a super position of periods, or in a noise timed way.

7. Circuit arrangement according to Claim 6, **characterised in that** at least one of the at least two sub-groups consists of a single cell.

8. Circuit arrangement according to Claim 6, **characterised in that** all cells of the serial circuit are each connected with a separate load.

9. Circuit arrangement according to one of the Claims 6 to 8, **characterised in that** the loads comprise defined electrical characteristics such as ohmic resistances, capacities, or inductivities.

10. Circuit arrangement according to one of the Claims 6 to 9, **characterised in that** the measuring arrangement for the measurement of power and voltage is equipped with devices such as lock-in amplifiers, filters, or equipment for carrying out a Fourier or Laplace analysis for detecting the alternating voltage and/or alternating current components of the timed sequences of the individual cell voltages, e.g. the power flowing through the individual cells.

11. Circuit arrangement according to one of the Claims 8 to 10, **characterised in that** the loads have defined electrical characteristics such as ohmic resistances, capacities, or inductivities.

12. Circuit arrangement according to Claim 11, **characterised in that** the electrical characteristics of the loads are timed differently for supplying a relevant defined and differently timed power to the cells.

13. Circuit arrangement according to Claim 12, **characterised in that** the electrical characteristics of the loads are designed periodically, with a super position of periods, or in a noise timed changeable way.

14. Circuit arrangement according to one of the Claims 12 or 13, **characterised in that** the measuring arrangement for measuring power and voltage is equipped with devices such as lock-in amplifiers, filters, or equipment for carrying out a Fourier or Laplace analysis for detecting the alternating voltage and/or alternating current components of the timed sequences of the individual cell voltages, e.g. the power flowing through the individual cells.

## Revendications

1. Procédé de mesure de propriétés électriques de cellules électrochimiques montées en série, dans lequel le courant qui s'écoule dans les cellules chargées et les tensions appliquées entre les pôles des différentes cellules du montage en série sont mesurés simultanément, le courant qui s'écoule dans les cellules étant mesuré séparément pour au moins deux sous-groupes de cellules lors du chargement de manière groupée des sous-groupes avec des charges séparées (Lᵢ), **caractérisé en ce que** les cellules, par le biais de charges qui présentent une variation périodique de leurs propriétés électriques et une variation temporelle avec une superposition de périodes ou à la manière du bruit, sont alimentées avec un courant défini qui est constitué d'une composante de courant continu et d'une composante de courant alternatif ayant une certaine fréquence ou une superposition de plusieurs fréquences ou qui comprend une composante de bruit.

2. Procédé selon la revendication 1, **caractérisé en ce que** l'un au moins desdits au moins deux sous-groupes est formé par une cellule unique.

3. Procédé selon la revendication 1, **caractérisé en ce que** le courant qui s'écoule dans les cellules est mesuré séparément pour chaque cellule en appliquant séparément à chaque cellule une charge qui lui est propre.

4. Procédé selon l'une des revendications 1 à 3, **caractérisé en ce que** les cellules sont alimentées avec un courant respectif défini en choisissant des charges ayant chacune des propriétés électriques définies telles que des résistances ohmiques, des capacités ou des inductances.

5. Procédé selon l'une des revendications 1 à 4, **caractérisé en ce que** les composantes de tension alternative et/ou les composantes de courant alternatif des profils temporels des différentes tensions de cellules ou des courants qui s'écoulent dans les différentes cellules sont déterminées par des procédés tels que l'amplification synchrone, le filtrage, l'analyse de Fourier ou l'analyse de Laplace.

6. Agencement de circuit pour mesurer des propriétés électriques de cellules électrochimiques montées en série au moyen d'un montage de mesure du courant qui s'écoule dans les cellules chargées et des tensions appliquées entre les pôles des différentes cellules du montage, les cellules étant chargées par groupes avec des charges séparées (Lᵢ) dans au moins deux sous-groupes, **caractérisé en ce que** les charges présentent une variation périodique de leurs propriétés électriques et une variation temporelle avec une superposition de périodes ou à la manière du bruit.

7. Agencement de circuit selon la revendication 6, **caractérisé en ce que** l'un au moins desdits au moins deux sous-groupes est constitué d'une cellule unique.

8. Agencement de circuit selon la revendication 6, **caractérisé en ce que** toutes les cellules du montage en série sont reliées chacune à une charge séparée.

9. Agencement de circuit selon l'une des revendications 6 à 8, **caractérisé en ce que** les charges ont des propriétés électriques définies telles que des résistances ohmiques, des capacités ou des inductances.

10. Agencement de circuit selon l'une des revendications 6 à 9, **caractérisé en ce que** le montage de mesure de courant et de tension est équipé de dispositifs tels que des amplificateurs synchrones, des filtres ou des appareils d'analyse de Fourier ou de Laplace, afin de déterminer les composantes de tension alternative et/ou de courant alternatif des profils temporels des différentes tensions de cellules ou des courants qui s'écoulent dans les différentes cellules.

11. Agencement de circuit selon l'une des revendications 8 à 10, **caractérisé en ce que** les charges ont des propriétés électriques définies telles que des résistances ohmiques, des capacités ou des inductances.

12. Agencement de circuit selon la revendication 11, **caractérisé en ce que** les charges sont réalisées avec des propriétés électriques variables dans le temps pour charger les cellules chacune avec un courant défini variable dans le temps.

13. Agencement de circuit selon la revendication 12, **caractérisé en ce que** les charges sont réalisées avec des propriétés électriques variables périodiquement et variables dans le temps avec une superposition de périodes ou à la manière du bruit.

14. Agencement de circuit selon l'une des revendications 12 ou 13, **caractérisé en ce que** le montage de mesure de courant et de tension est équipé de dispositifs tels que des amplificateurs synchrones, des filtres ou des appareils d'analyse de Fourier ou de Laplace, afin de déterminer les composantes de tension alternative et/ou de courant alternatif des profils temporels des différentes tensions de cellules ou des courants qui s'écoulent dans les différentes cellules.
